# EUROPEAN PATENT SPECIFICATION

(11) **EP 2 764 133 B1**
(45) Date of publication and mention of the grant of the patent: **18.12.2019**
(21) Application number: 12770196.9
(22) Date of filing: 26.09.2012
(51) Int. Cl.: C23C 16/455, C23C 16/02, C23C 16/54

(54) **A METHOD FOR PRODUCING A COATING BY ATMOSPHERIC PRESSURE PLASMA TECHNOLOGY**
VERFAHREN ZUR HERSTELLUNG EINER BESCHICHTUNG MITTELS ATMOSPHÄRISCHEN DRUCKS UND PLASMATECHNOLOGIE
PROCÉDÉ DE FORMATION D'UN REVÊTEMENT PAR TECHNOLOGIE PLASMA À PRESSION ATMOSPHÉRIQUE

(30) Priority: 06.10.2011 GB 201117242
(43) Date of publication of application: 13.08.2014
(73) Proprietor: Fujifilm Manufacturing Europe BV, 5047 TK Tilburg (NL)
(72) Inventor: DE VRIES, Hindrik, NL-5047 TK Tilburg (NL); STAROSTINE, Serguei, NL-5047 TK Tilburg (NL)
(74) Representative: Revell, Christopher
(86) International application number: PCT/GB2012/052378
(87) International publication number: WO 2013/050741

(56) References cited:
- EP-A1- 2 226 832
- EP-A1- 2 245 647
- WO-A1-2007/145513
- US-A1- 2011 049 730
- US-A1- 2011 049 730

## Description

The invention relates to a method for manufacturing a barrier layer on a flexible substrate. The present invention further relates to a substrate comprising a very thin barrier layer.

### BACKGROUND

Atomic layer deposition (ALD) is used in the art to provide layers of a material on the surface of a substrate. Different from chemical vapor deposition (CVD) and physical vapor deposition (PVD), atomic layer deposition (ALD) is based on saturated surface reactions. The intrinsic surface control mechanism of ALD process is based on the saturation of an individual, sequentially-performed surface reaction between the substrate reactive sites and precursor molecules. The saturation mechanism makes the film growth rate directly proportional to the number of reaction cycles instead of the reactant concentration or time of growth as in CVD and PVD.

ALD is a self-limiting reaction process, i.e. the amount of deposited precursor molecules is determined only by the number of reactive surface sites on the substrate surface and is independent of the precursor exposure after saturation. The ALD cycle is composed of several steps. In general it is performed in one single treatment space. It starts with providing the surface of a substrate with reactive sites. As a next step a precursor is allowed to react with the reactive sites and the excess material and reaction products are purged out of the treatment space and, ideally, a monolayer of precursor remains attached to the substrate surface via the reactive surface sites. A reactive agent is introduced into the treatment space as next step and reacts with the attached precursor molecules to form a monolayer of the desired material having reactive sites again, after which unreacted material and by-product is purged out. Optionally the cycle is repeated to deposit additional monolayers. With each cycle basically one atomic layer can be deposited which allows a very accurate control of film thickness and film quality.

In the prior art, several methods have been developed to enhance the reaction step in this ALD process, e.g. thermal ALD and plasma assisted ALD. The plasma as used in known ALD methods may be for example a low pressure RF driven plasma or an inductively-coupled plasma (ICP) or capacitively-coupled plasma (CCP), and may be used to deposit Al₂O₃, HfO₂, Ta₂O₅ and many other materials.

International patent publication WO01/15220 describes a process for deposition of barrier layers in integrated circuits, in which ALD is used. In the ALD steps, low pressure is used (of about 10 Torr (1330 Pa)) in combination with a thermal reaction step at a high temperature (up to 500°C). Alternatively it is suggested to use a plasma to produce a reactive environment. All disclosed embodiments describe a very low pressure environment, requiring special measures in the apparatus used.

US patent application US2004/0219784 describes methods for forming atomic layers and thin films, using either thermal reaction steps, or plasma assisted reaction steps, in which radicals are formed remotely form the substrate and transported thereto. Again, these processes are performed at relatively high temperature (100-350°C) and low pressure (almost vacuum, typically 0.3 to 30 Torr (40 to 4000 Pa)).

US patent application US2003/0049375 discloses a CVD process to deposit a thin film on a substrate using a plasma assisted CVD process at low pressure. The formation of a plurality of atomic layers is claimed. The known ALD methods as described above are mainly performed under low pressure conditions, and thus require vacuum equipment. Furthermore, the ALD methods described using thermal reaction steps (at temperatures well above room temperature, e.g. even 300-900°C), are not suitable for deposition of material on temperature sensitive substrates, such as polymer substrates.

WO2007145513 from applicant and hereby incorporated by reference discloses by using plasma assisted atomic layer deposition (ALD) water vapor barrier properties can be found in the range of 4^{∗} 10⁻³ g/m^{2∗}day with a film thickness as low as 10-20 nm thick due to well controlled film growth and high conformality covering irregularities on the surface. However typically more than 100 ALD cycles are needed to achieve this property as for example the maximum growth rate of Al₂O₃ grown by ALD is typically 0.07∼0.11 nm/ cycle. Due to low film thickness growth per cycle in ALD this sets a limit to the productivity of the ALD process particularly for high volume applications like barrier films.

Patent documents WO 2009 104 957 and US 2011/0049730 A1 disclose plasma deposition processes for the formation of barrier layers.

It is an object of the invention to provide a faster and more efficient method for creating an improved barrier on a substrate, in particular on a flexible substrate.

### SUMMARY OF THE INVENTION

According to the present invention, it has been found that excellent water vapor barrier layers can be made on flexible substrates having an inorganic oxide layer on top in a rather efficient and fast mode using atmospheric pressure discharge plasma. According to a present invention embodiment, a method is provided for manufacturing a barrier layer on a flexible substrate, the method comprising a first step comprising depositing an inorganic oxide layer on the flexible substrate using an atmospheric pressure plasma and a second step comprising consecutive deposition of between 1 and 70 atomic layers on the inorganic oxide layer.

Surprisingly we have found that after an ultra-fast deposition step of an inorganic layer in the first step (resulting in no to little barrier improvement) by using an atmospheric pressure plasma on a flexible substrate an excellent water vapor property can be reached by far less ALD cycles than on samples prepared on substrates treated only by ALD and not having undergone the first step of the present embodiment.

In an embodiment of the present invention, the first step is executed using an atmospheric pressure glow discharge (APGD) plasma apparatus. This provides for a very efficient and uniform deposition of the inorganic oxide layer.

In one embodiment the first step comprises deposition of the inorganic oxide layer with a thickness between 10 and 100 nm. In exemplary embodiments the inorganic oxide layer is a silicon oxide layer from which the thickness may vary between 10 and 100 nm. In case of speed of the process being relevant, the thickness is as low as possible i.e. 20, 25, 30, 35, 40, 50, 60, 65, 70, 75, 80 or 90 nm.

In a further embodiment, the ALD layer deposited in the second step is Al₂O₃ having a thickness of between 0.5 to 10 nm, preferably between 1 to 10nm. Also here in case the speed of the process being relevant, the thickness is as low as possible i.e. 1, 2, 3, 4, 5, 6, 7, 8 or 9 nm.

E.g. when using a 70 nm thin SiO₂ layer deposited using an atmospheric pressure glow discharge plasma, a water vapor transmission rate of 4.8 ^{∗} 10⁻³ g/m^{2∗} day (40°C/100%RH) barrier was observed after 7 cycles of ALD. The substrate made by the invention method in this particular case comprises an ALD layer of only 1 nm thick.

By use of the APGD system in the first step of the present invention an inorganic oxide layer may be deposited at high deposition rates between 20 and 200 nm/s and results in a layer having no or little moisture barrier improvement compared to the bare flexible substrate whereon it has been deposited. The inorganic layer resulting after the first step of the present invention embodiments is preferably a layer having a free pore volume of between 0.3 and 10%, more preferably between 0.3 and 3%.

Typically the treated substrates do not possess a good water vapor barrier property after the first step deposition and are in general not better than the barrier properties of the bare polymer substrate.

Preferred precursors which may be used for forming an inorganic oxide layer as first step in the present invention on a flexible substrate by using an atmospheric pressure glow discharge plasma are for example TEOS, HMDSO, TPOT, TEOT, TMA, TEA, etc. as disclosed in WO 2009 104 957 by applicant and is hereby incorporated by reference.

The flexible substrate may be any kind of polymeric film. In an exemplary embodiment PET or PEN film is used having a thickness of 50 to 200 µm.

Other examples of substrate which may be used are transparent sheets of ethylene vinyl acetate (EVA), of polyvinyl butyral (PVB), of polytetrafluoroethylene (PTFE), perfluoroalcoxy resins (PFA), i.e., copolymers of tetrafluoroethylene and perfluoroalkyl vinyl ether, tetafluoroethylene-hexafluoropropylene copolymers (FEP), tetrafluoroethylene-perfluoroalkyl vinyl ether-hexafluoro-propylene copolymers (EPE), tetrafluoroethylene-ethylene or propylenecopolymers (ETFE), polychlorotrifluoroethylene resins (PCTFE), ethylene-chlorotrifluoroethylene copolymers (ECTFE), vinylidene fluoride resins (PVDF), and polyvinyl fluorides (PVF) or coextruded sheets from polyester with EVA, polycarbonate, polyolefin, polyurethane, liquid crystal polymer, aclar, aluminum, of sputtered aluminum oxide polyester, sputtered silicon oxide or silicon nitride polyester, sputtered aluminum oxide polycarbonate, and sputtered silicon oxide or silicon nitride polycarbonate.

In the present invention embodiments the exact type of ALD process in the second step is not very relevant. In one embodiment, the second step is executed using a plasma assisted atomic layer deposition (ALD), and in a further embodiment, the second step is executed using a thermal atomic layer deposition (ALD) step. Variants of ALD equipment using such techniques may also be used, such as low pressure inductively-coupled plasma (ICP) or capacitively-coupled plasma (CCP) or RF driven plasma or thermal ALD.

In a further aspect, the present disclosure relates to an apparatus for manufacturing a barrier layer on a substrate, the apparatus comprising:
- an atmospheric pressure glow discharge (APGD) plasma apparatus comprising at least two electrodes arranged to generate an atmospheric pressure glow discharge plasma in a treatment space formed between said two electrodes, and
- an atomic layer deposition (ALD) device,
wherein the apparatus is arranged to provide an inorganic layer on the substrate using the atmospheric pressure glow discharge (APGD) plasma apparatus, and to provide a consecutive deposition of between 1 and 70 atomic layers on the inorganic oxide layer using the ALD device.

In a further embodiment, the ALD device comprises a treatment space and gas supply devices for providing various gas mixtures to said treatment space, the gas supply device being arranged to provide a gas mixture comprising a precursor material to the treatment space for allowing reactive surface sites to react with precursor material molecules to give a surface covered by a monolayer of precursor molecules attached via the reactive sites to the surface of the substrate in the first treatment space and to provide a gas mixture comprising a reactive agent capable to convert the attached precursor molecules to active precursor sites. The various steps and interposed purging steps may be executed in a single treatment space.

In an even further embodiment, the atmospheric pressure glow discharge (APGD) plasma apparatus comprises at least two opposing electrodes and a treatment space between the at least two opposing electrodes, a dielectric barrier being provided in the treatment space between the at least two opposing electrodes and comprising in operation the substrate, the at least two opposing electrodes being connected to a plasma control unit for generating an APGD plasma in the treatment space.

The ALD device comprises at least two separate treatment spaces having a first and second gas supply devices for providing various gas mixtures to the at least two treatment spaces in a further embodiment. The first gas supply device is operated to provide a gas mixture comprising a precursor material to the treatment space for allowing reactive surface sites on the substrate surface to react with precursor material molecules to provide a surface of the substrate covered by a monolayer of precursor molecules attached via the reactive sites to the surface of the substrate in the first treatment space, and the second gas supply is operated to provide a gas mixture comprising a reactive agent capable to convert the attached precursor molecules to active precursor sites, the method further comprising moving the substrate between the first and second treatment spaces, and generating an atmospheric pressure plasma in the gas mixture comprising the reactive agent.

In an even further embodiment, the atomic layer deposition (ALD) device comprises a plurality of first and second treatment spaces placed sequentially one behind the other in a circular or linear arrangement.

When different treatment spaces exist, they may be connected via a transport device which is capable to transport the substrate from treatment space to treatment space.

The at least two electrodes are roll electrodes in a further embodiment, and the flexible substrate is moved through the treatment spaces continuously.

An even further aspect of the present invention is related to a substrate with a very thin barrier layer having improved barrier properties and robustness property after exposure in water-saturated vapor conditions. In one embodiment, the flexible barrier substrate comprises a 10 to 100 nm thick inorganic oxide layer having a free pore volume of 0.3 to 10 % and a 0.5 to 10 nm ALD layer (e.g. a free pore volume of 0.3 to 3 % and a 1 to 10 nm ALD layer). In a further embodiment, the flexible substrate comprises a 10 to 100 nm thick inorganic oxide layer having a free pore volume of 0.3 to 10% and 0.5 to 5 nm ALD layer (e.g. a free pore volume of 0.3 to 3 % and a 1 to 5 nm ALD layer). In an even further embodiment, the flexible substrate comprises a 10 to 100 nm thick SiO₂ layer having a free pore volume of 0.3 to 10 % and a 0.5 to 5 nm Al₂O₃ ALD layer (e.g. a free pore volume of 0.3 to 3 % and a 1 to 5 nm Al₂O₃ ALD layer). All embodiments are made using the present invention method embodiments. The flexible substrates thus obtained are produced in a fast and efficient manner and have excellent water vapor barrier properties which could not be reached by both steps separate and deposited alone (i.e. the first step without the second step deposition or the second step without the first step deposition).

### SHORT DESCRIPTION OF THE FIGURES

The present invention will be discussed in more detail below, using a number of exemplary embodiments, with reference to the attached drawings, in which
Fig. 1a/b shows schematic views of an embodiment of the invention of the first step of the present method.
Fig. 2 shows a schematic view of the ALD-step
Fig. 3 shows an exemplary view of the second step using an APGD assisted spatial ALD.
Fig. 4 shows a cross sectional view of a substrate with an inorganic oxide layer and a ALD layer.

### DETAILED DESCRIPTION OF THE EXAMPLES

The present invention will now be described in reference to exemplary embodiments of the invention.

According to the present invention, a faster and more efficient procedure is provided for manufacturing a water vapor barrier on a flexible polymer substrate. A method is provided for manufacturing a barrier layer 1b on a flexible substrate 1, the method comprising a first step comprising depositing an inorganic oxide layer 1a on the flexible substrate 1 using an atmospheric pressure plasma and a second step comprising consecutive deposition of between 1 and 70 atomic layers on the inorganic oxide layer 1a. Furthermore, according to the present disclosure, an apparatus for manufacturing a barrier layer 1b on a substrate 1, the apparatus comprising an atmospheric pressure glow discharge (APGD) plasma apparatus comprising at least two electrodes 2, 3 arranged to generate an atmospheric pressure glow discharge plasma in a treatment space 5 formed between said two electrodes 2, 3 and an atomic layer deposition (ALD) device, wherein the apparatus is arranged to provide an inorganic oxide layer 1a on the substrate 1 using the atmospheric pressure glow discharge (APGD) plasma apparatus, and to provide a consecutive deposition of between 1 and 70 atomic layers (1b) on the inorganic oxide layer 1a using the ALD device.

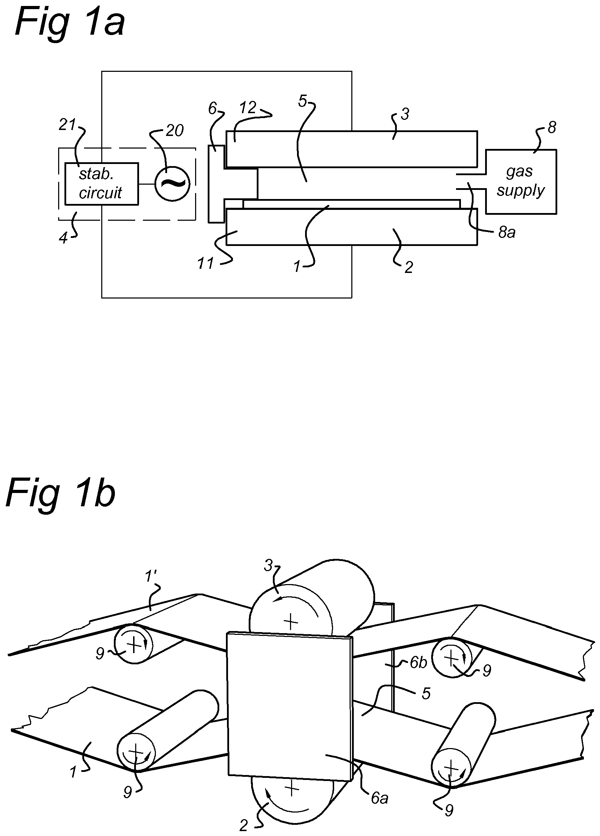

Fig. 1a and b show schematic views of exemplary embodiments of an atmospheric pressure glow discharge (APGD) plasma apparatus in which a first step of the present method embodiments according to the present invention may be practiced. A treatment space 5, which may be a treatment chamber within an enclosure (not shown in Fig. 1a), or a treatment space 5 with an open structure, comprises two electrodes 2, 3. In general the electrodes 2, 3 are provided with a dielectric barrier in order to be able to generate and sustain a glow discharge at atmospheric pressure in the treatment space. The dielectric barrier may be formed in operation by the substrate 1 to be treated. In the embodiment shown in Fig 1a, the electrodes 2, 3 are planar electrodes, and the treatment space 5 is a rectangular space. A side tab 6 is provided to close off the treatment space 5 on one side. A gas supply 8 is provided in order to provide relevant substances into the treatment space 5, as discussed in more detail below. Finally, the electrodes 2, 3 are connected to a power supply 4, as discussed in more detail below.

Other forms of the electrodes 2, 3 and of the gap or treatment space 5 are possible, e.g. as part of a cylindrical arrangement of the plasma treatment apparatus. E.g., the treatment space may be cylindrical, or elliptic, or have another form adapted to treat a specific type of substrate 1. Both electrodes 2, 3 may have the same configuration being flat orientated (as shown in Fig. 1a) or both being roll-electrodes (as shown in the exemplary embodiment of the plasma treatment apparatus as shown in Fig. 1b). Also different configurations may be applied, e.g. using a roll electrode and a flat or cylinder segment shaped electrode opposing each other. In further embodiments, the electrodes may be multi-segment electrodes. Embodiments using more than two electrodes are also imaginable.

In general the atmospheric pressure glow discharge plasma is generated between the two electrodes 2, 3 in the treatment space 5. Alternatively a plurality of electrodes 2, 3 is provided. In case the electrodes 2, 3 have a surface area which is at least as big as the substrate 1, the substrate 1 can be fixed in the treatment space 5 between the two electrodes 2, 3.

Fig. 1b shows a further embodiment of a plasma treatment apparatus wherein two substrates 1,1' are treated simultaneously. In this alternative embodiment, not one substrate 1 but two substrates (1, 1') are positioned in the treatment space 5 (and two side tabs 6a, 6b) in a fixed way or moving at a certain speed in the treatment space 5 to utilize the gas supply 8 even more efficiently.

In case the substrate 1 is larger than the electrode area, the substrate 1,1' may be moved through the treatment space 5, e.g. at a linear speed using a roll-to-roll configuration, an example of which is shown in the embodiment of Fig. 1b. The substrates 1, 1 are guided in close contact with the roller shaped (roll) electrodes 2, 3, using guiding rollers 9. A roll-electrode is e.g. implemented as a cylinder shaped electrode, mounted to allow rotation in operation e.g. using a mounting shaft or bearings. Such a roll-electrode may be freely rotating, or may be driven at a certain angular speed, e.g. using well known controller and drive units. The side tabs 6a, 6b are positioned at the roller end faces, thereby creating a closed off treatment space 5 between the electrodes 2, 3.

The electrodes 2, 3 are connected to a power supply 4 (see embodiment of Fig. 1a), which is arranged to provide electrical power to the electrodes for generating the atmospheric pressure glow discharge (APGD) plasma.

The power supply 4 can be a power supply providing a wide range of frequencies for example f = 10 kHz - 30MHz .

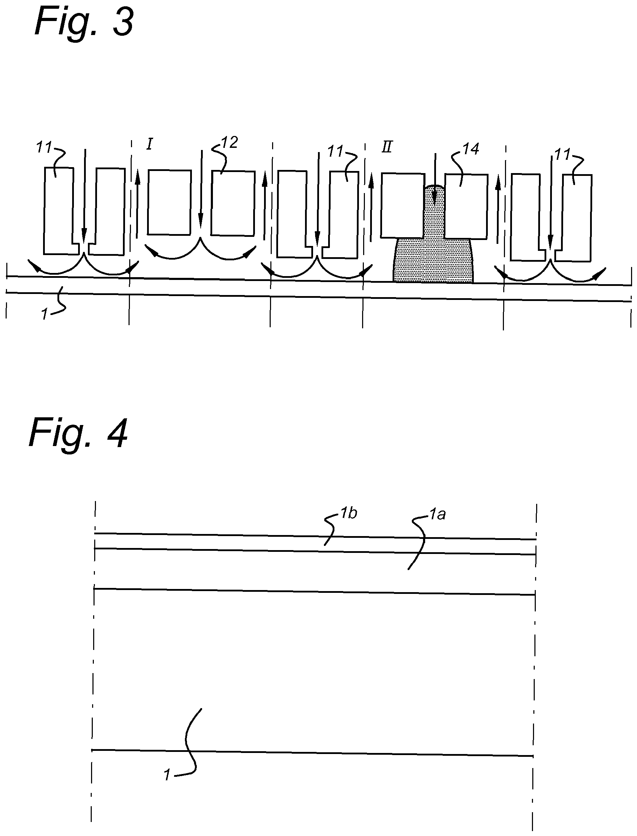

Very good results can be obtained by using an atmospheric pressure glow discharge (APGD) plasma as this step can be done ultra-fast. As a result of the first deposition step an inorganic oxide layer 1a is provided on the substrate 1 (see cross sectional view in Fig. 4). It was shown that this inorganic oxide layer 1a in itself is not really improving the barrier properties versus that of the bare polymer substrate 1.

Until recently APGD plasmas suffered from a bad stability, but using the stabilization circuits as for example described in US 6774569, EP 1383359, EP 1547123 and EP 1626613 (which are incorporated herein by reference), very stable APG plasmas can be obtained in a treatment space 5. In general these plasmas are stabilized by a stabilization circuit 21 (as shown Fig. 1a) counteracting local instabilities in the plasma. Using the stabilization circuit 21 in combination with an AC power source 20 in the power supply 4 for the plasma generating apparatus results in a controlled and stable plasma, without streamers, filamentary discharges or other imperfections.

In one embodiment the apparatus of the present disclosure including the stabilization circuit 21 is used to generate an atmospheric glow discharge plasma in a gas composition including a precursor for a compound or element to be deposited by which a single layer may be deposited. In another embodiment multiple layers of compound or element may be deposited by having multiple passes of the substrate 1 through the treatment space 5, or by having several treatment spaces 5 placed in series with each other. In this last embodiment layers of different composition can be applied over each other in a very efficient way, having a thickness of each layer of 1 nm or more.

In the plasma treatment apparatus a gas supply device 8 is arranged in order to direct gas comprising at least one precursor towards an inner region of the substrate 1 to be processed, as shown in Fig. 1a. A gas supply inlet may be used to direct the gas into the treatment space 5, e.g. towards the surface of the substrate 1. The supply device 8 also acts as the main carrier gas supply. A carrier gas may be used such as Argon, Helium, Nitrogen etc., to form the plasma, as an additive or mixture to reduce the breakdown voltage. The use of the precursor is to have the precursor decomposed in the treatment space or gap 5 to a chemical compound or chemical element which is ultra-fast deposited on the substrate 1 as inorganic oxide layer 1a (having active hydroxyl surface sites) having a pores vol. % between 0.3 and 10%.

A gas supply inlet may be used to direct the gas into the treatment space 5 as shown in EP 2 226 832 by applicant and hereby incorporated by reference. The gas supply device 8 may be provided with storage, supply and mixing components as known to the skilled person. Preferred precursors are TEOS and HMDSO resulting in a deposited layer 1a of 10 to 100 nm silicon oxide on substrate 1.

According to the present invention embodiments, a time-wise faster and thus more efficient process for forming a barrier layer on a (flexible) substrate 1 is provided. A second step of atomic layer deposition (ALD) is provided in addition to forming an inorganic layer using an atmospheric pressure glow discharge plasma in a first step.

As second step of the method embodiments according to the present invention the type of ALD process itself is not relevant. The second step of ALD is not limited to vacuum (batch) processing but can be done at atmospheric pressure in any of the thermal, ozone or plasma assisted ALD methods which are known as such, using a spatial scheme to enable roll-to-roll processing.

The second step may be done by (spatial) plasma assisted ALD as for example an atmospheric pressure glow discharge (APGD) plasma as disclosed by applicant in WO2007145513 and WO2009031886 and hereby incorporated by reference.

In the second step of the present invention embodiments, using ALD in several consecutive cycles a very thin second layer 1b is grown of about 1 to 10 nm on top of the inorganic oxide layer 1a (formed in the first step), as shown in the cross sectional view of Fig. 4. It has been surprisingly found that this two step process results in an excellent barrier (layer 1a and layer 1b on top of substrate 1) having water vapor transmission rates (WVTR) in the range of about 5^{∗}10⁻⁴ g/m^{2∗}day or less although both steps separate and deposited alone (i.e. the first step without the second step deposition or the second step without the first step deposition) would not result in an improved moisture barrier film compared to the bare substrate alone. As a result a far more efficient and fast process is realized for getting an excellent barrier on flexible substrates 1 as it needs only about 5 to 70 ALD cycles to grow the second layer 1b in the present method embodiments compared to prior art methods which needed much more than 200 cycles of ALD to obtain a similar WVTR.

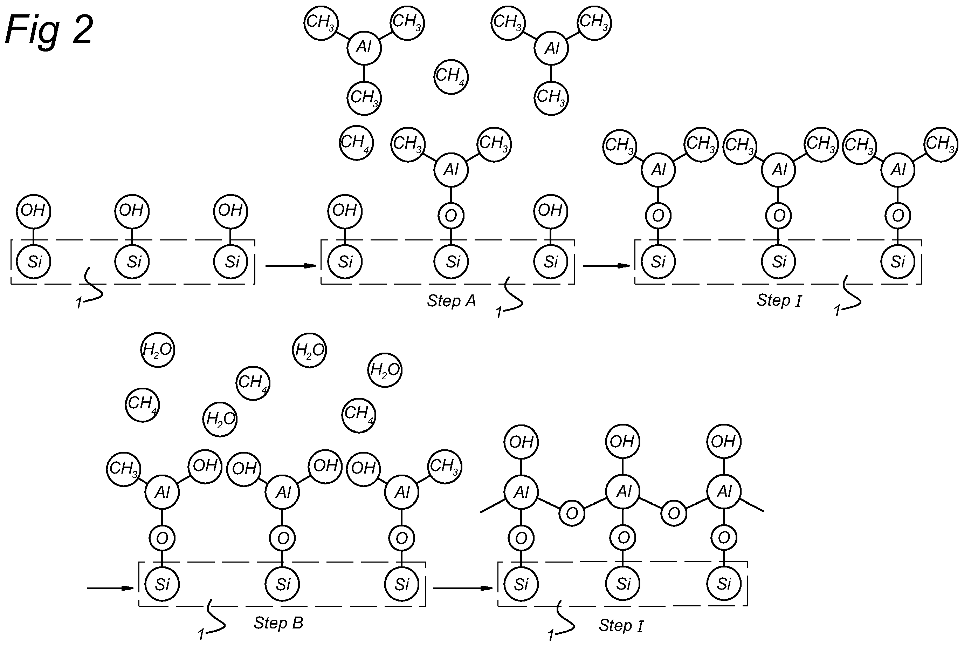

The second (ALD) step of the present invention embodiments is sub-divided in four steps (so-called A/I/B/I steps), as shown schematically in Fig. 2. At the left side, a substrate 1 is shown comprising Si atoms, which form reactive surface sites with OH-groups. In the A-step precursor material is supplied to the surface of the substrate 1 for allowing reactive surface sites to react with precursor material molecules to give a surface covered by a monolayer of precursor molecules attached via the reactive sites to the surface of the substrate. In the B-step the surface covered with precursor molecules is exposed to a reactive agent capable to convert the attached precursor molecules to active precursor sites (OH groups). The steps of providing precursor material and of exposing the surface to a reactive agent may be repeated consecutively in order to obtain multiple layers of material on the substrate surface. In between steps A and B I-steps (purge steps) are included to remove excess and reaction products from the treatment space 5.

The second step of the present invention embodiments can be done in one treatment space. The gas supply devices 8 for the A/I/B/I-step are arranged to control the ALD process properly.

Advantageously in the process is further that the ALD step may be done using at least two separate treatments spaces (one for the precursor step) and the second (for the plasma assisted reaction step) as is shown schematically for an exemplary embodiment (a spatial assisted ALD equipment) in Fig. 3 for enabling a fast second process step. Here the substrate 1 is moved at a constant speed underneath consecutive treatment spaces, separated from each other by gas bearings 11. The gas bearings 11 allow separation between treatment areas I and II, and also allow to enhance purging steps in the plasma treatment apparatus. In the first treatment area I, a special gas supply 12 is used to enter a precursor material, such as TMA, in the treatment space above substrate 1. In the second treatment area II, a plasma is generated using plasma generator 14, and a reactive agent (such as ozone, water or a nitrogen comprising agent) or reactive mixture comprising an reactive agent (such as ozone, water or a nitrogen comprising agent) and an inert gas selected from a noble gas such as helium, argon, nitrogen or a mixture of these gases.

In the embodiment of Fig. 3, implementing the second step of the present invention embodiment is done using at least four separate treatment spaces wherein purge steps may be included in between treatment space I and II, e.g. using an inert gas or inert gas mixture to remove the excess of precursor molecules (in treatment space I) and/or the molecules formed in the reaction (in treatment space II). This will enable to treat the substrate 1 continuously through the ALD device as it makes the process more efficient using a moving substrate 1.

Use of an atmospheric plasma obviates the need to work at very low pressure. So the use of an atmospheric pressure plasma assisted ALD process step may be used advantageously too. Hence no complex constructions are necessary to obtain a vacuum or near vacuum at the substrate surface during processing, thus enabling roll to roll atmospheric barrier film manufacture.

Further the use of a spatial atmospheric plasma makes it possible to make the process even more efficient as the ALD of the second step of the invention method may be done consecutively and continuously using a moving web-substrate as shown in Fig.2.

The precursor material is e.g. tri-methyl-aluminum (TMA) as shown in Fig.2, which allows to grow Al₂O₃ layers 1a, 1b on e.g. a SiO₂₋substrate 1. Other examples of precursor materials are all alkyl- aluminum compounds like tri-ethyl aluminum (TEA), Aluminum halides like ALCl₃ or AlBr₃, HfCl₄, TEMAH (tetrakisethyl methylaminohafnium, TiCl₄, Ti(OEt)₄ or Ti(OⁱPr)4 or SiCl4 or ZrCl4, Zr(O^{t}Bu)4, ZrI4, ZnEt₂, Zn(OAc)₂, SnCl₄, SnI₄, TaCl₅, Ta(OEt)₅.

According to a further embodiment, the precursor material is provided in a concentration of between 0.1 and 5000 ppm. This concentration is sufficient to obtain a uniform layer of precursor molecules on the substrate surface in the second step of the present method embodiments.

The reactive agent mixture may in a further embodiment comprise an inert gas selected from a noble gas such as helium, nitrogen or a mixture of these gases.

In a further embodiment, the reactive agent is a reactive gas, such as oxygen, an oxygen comprising agent such as ozone or water, a nitrogen comprising agent, etc..

In an even further embodiment, the gas mixture of the reactive agent and inert gas of the second step of the present invention comprises between 1 and 50% reactive agent. This is sufficient to have a good reaction result in the second step of the present method embodiments.

The disclosure is furthermore directed to an apparatus which is capable of executing the method embodiments of this invention, such as the apparatus embodiments shown in Fig, 1a, 1b, and 3, or combinations thereof.

Further the invention is directed to a flexible barrier substrate 1 having a thin inorganic oxide layer 1a having a free pore volume between 0.3 and 10% and a thin ALD layer 1b between 0.5 and 10 nm thick (see Fig. 4) for example 0.5 or 1 or 2 or 3 or 4 or 5 nm thick.

### EXAMPLES

WVTR (water vapor transmission rate) is determined using a Mocon Aquatran Model 1 which uses a coloumetric cell (electrochemical cell) with a minimum detection limit of 5^{∗}10⁻⁴ g/m^{2∗}day. This method provides a more sensitive and accurate permeability evaluation than the permeation measurement by using IR absorption. All measurements were done at 40°C/100%RH.

Film thickness is characterized using a Woollam Spectroscopic Ellipsometer type D2000 and the optical density (refractive index) was measured using a vacuum chamber and heating stage implemented on the Spectroscopic Ellipsometer. The free pore volume of the inorganic oxides was determined using the Lorentz-Lorenz equations by measuring the optical density difference of the material.

Based on the ellipsometric measurement a growth rate of 0.12 nm/cycles was determined for the ALD-process.

Several examples 1 and 6-14 were prepared by depositing on a PEN Q65-FA (100 µm thick) substrate 1 by using a APGD-CVD plasma apparatus as disclosed in WO 2009 104 957 in a treatment space 5 using a plasma power of 600 W, an excitation frequency of 200 kHz and a gas composition (95% N₂/5% O₂) using TEOS precursor (3 ppm) with a DR of 60 nm/s resulting in a 70 nm SiO₂ -layer 1a (having active hydroxyl surface sites) in the first step of the present invention embodiments.

Example 1 is a comparative example: a SiOx layer 1a was deposited on a PEN Q65 substrate 1 by above described APGD-CVD but without the ALD treatment of the second step of the present invention. The free pore volume has been measured between 0.3-3% ; WVTR is 2 g/m^{2∗}day which is almost same as the WVTR of the bare PEN substrate 1.

Examples 6-10 are samples having the same first APGD-treatment as example 1 and as second step a spatial (vacuum) plasma assisted ALD treatment using OxfordFlexAl apparatus to deposit barrier films 1b of respectively about 0.5, 1, 2, 5 and 20 nm thick by transporting a substrate 1 respectively 5, 10, 20, 50 and 200 cycles through the ALD system as second step of the present invention. Conditions: vacuum 10⁻⁶ Torr; A step 20 ms TMA/ I purge step 1.5 s/B step 2 s plasma O₂ / I purge step 1.5 s; The films 1b were grown at a substrate temperature of 80°C by sequentially injecting the TMA and adding plasma assisted O₂ gas to the substrate 1.

Examples 11-14 are made by using a thermal ALD apparatus to deposit barrier films 1b of respectively about 1, 2, 5 and 20 nm thick by respectively 10, 20, 50 and 200 cycles through the thermal ALD system. The films 1b were grown at a substrate temperature of 90°C by sequentially injecting TMA as step A and H₂O as step B.

Examples 2-5 are comparative examples and are prepared on PEN Q65-FA substrates 1 (100 µm thick) by using a (vacuum) plasma assisted OxfordFlexAl ALD apparatus treatment in the same way as described for respectively examples 6-9 however without the first APGD step of the present invention.

Example 15 is a comparative example and is prepared on a PEN Q65-FA substrate 1 (100 µm thick) by using a thermal ALD system like for examples 11-14 however without the first APGD step of the present invention.

Example 16 is an inventive example and prepared under the same conditions as for example 6 however as substrate 1 a ST505 (Melinex) PET (100 µm thick) from DuPont Tejin is used.

Single Al₂O₃-layers are susceptible to damage by water vapor. The barrier properties of single layers 1a of Al₂O₃ (for examples 2-5) deteriorated markedly after 5 days when the ALD film was exposed to saturated H₂O vapor pressure. Surprisingly examples 6-14 do not show this phenomenon. The SiO₂ layer 1a is effective against this phenomenon showing robustness improvement for these samples.

In table 1 the examples and performance on the WVTR and the deterioration after 5 days at saturated water vapor is summarized.

**Table 1**

| Example | Substrate | APGD-CVD | | | ALD | | | | |
|---|---|---|---|---|---|---|---|---|---|
| | | first step | | | second step | | | | |
| | | Thickness [nm] | Pore volume (vol.%) | WVTR [g/m^{2∗} day] | Cycles | Estimated thickness [nm] | WVTR [g/m^{2∗}day] | Degradation after 5 days at saturated water vapour | Type ALD |
| 1 | PEN | 70 | 0.3-3% | 2 | - | - | - | - | - |
| 2 | PEN | 0 | - | 2.5 | 10 | 1 | 2.2 | Yes | plasma assisted |
| 3 | PEN | 0 | - | 2.5 | 20 | 2 | 1.8 | yes | plasma assisted |
| 4 | PEN | 0 | - | 2.5 | 50 | 5 | 1.6 ^{∗} 10⁻² | yes | plasma assisted |
| 5 | PEN | 0 | - | 2.5 | 200 | 20 | <5 ^{∗} 10⁻⁴ | yes | plasma assisted |
| 6 | PEN | 70 | 0.3-3% | 1.6 | 5 | 0.5 | 6.8 ^{∗} 10⁻³ | No | Plasma assisted |
| 7 | PEN | 70 | 0.3-3% | 1.6 | 10 | 1 | 4.8 ^{∗} 10⁻³ | No | plasma assisted |
| 8 | PEN | 70 | 0.3-3% | 1.6 | 20 | 2 | 3.3 ^{∗} 10" | No | plasma assisted |
| 9 | PEN | 70 | 0.3-3% | 1.6 | 50 | 5 | 8.6 ^{∗} 10⁻⁴ | No | plasma assisted |
| 10 | PEN | 70 | 0.3-3% | 1.6 | 200 | 20 | <5 ^{∗} 10⁻⁴ | No | plasma assisted |
| 11 | PEN | 70 | 0.3-3% | 1.6 | 10 | 1 | 8.1 ^{∗} 10⁻³ | No | Thermal |
| 12 | PEN | 70 | 0.3-3% | 1.6 | 20 | 2 | 5.1 ^{∗} 10⁻³ | No | Thermal |
| 13 | PEN | 70 | 0.3-3% | 1.6 | 50 | 5 | 1.3 ^{∗} 10⁻³ | No | Thermal |
| 14 | PEN | 70 | 0.3-3% | 1.6 | 200 | 20 | <5 ^{∗} 10⁻⁴ | No | Thermal |
| 15 | PEN | 0 | - | 2.5 | 200 | 20 | <5 ^{∗} 10⁻⁴ | yes | Thermal |
| 16 | PET | 70 | 0.3-3% | 2.0 | 5 | 0.5 | 7.4 ^{∗} 10⁻³ | No | Plasma assisted |

## Claims

1. A method for manufacturing a barrier layer on a flexible substrate, the method comprising:
- a first step comprising depositing an inorganic oxide layer on the flexible substrate using an atmospheric pressure plasma;
- a second step comprising consecutive deposition of between 1 and 70 atomic layers on the inorganic oxide layer by atomic layer deposition.

2. Method according to claim 1, wherein the first step is executed using an atmospheric pressure glow discharge plasma apparatus.

3. Method according to any one of the preceding claims, wherein the first step comprises deposition of the inorganic oxide layer with a thickness between 10 and 100 nm.

4. Method according to any one of the preceding claims, wherein the first step comprises deposition of the inorganic oxide layer, the inorganic oxide layer having a free pore volume between 0.3 and 10 %.

5. Method according to any one of the preceding claims, wherein the second step is executed using a plasma assisted atomic layer deposition.

6. Method according to any of the claims 1-5, wherein the second step is executed using a thermal atomic layer deposition step.

7. Method according to any one of the preceding claims, wherein the inorganic oxide layer is a silicon-oxide layer.

8. Method according to any of the preceding claims, wherein the layer deposited by atomic layer deposition in the second step is Al₂O₃ having a thickness of between 0.5 to 10 nm.

9. Method according to any of claims 1 to 7, wherein the layer deposited in the second step by atomic layer deposition is Al₂O₃ having a thickness of between 0.5 and 5 nm.

10. Method according to claim 2, wherein in the first step an inorganic oxide layer is deposited at a deposition rate between 20 and 200 nm/s.

11. Method according to any of the preceding claims, wherein the flexible substrate is a PET or PEN film having a thickness of 50 to 200µm.

12. Method according to any of claims 1 to 10, wherein the substrate is a transparent sheet of ethylene vinyl acetate (EVA), of polyvinyl butyral (PVB), of polytetrafluoroethylene (PTFE), perfluoroalcoxy resins (PFA), i.e., copolymers of tetrafluoroethylene and perfluoroalkyl vinyl ether, tetafluoroethylene-hexafluoropropylene copolymers (FEP), tetrafluoroethylene-perfluoroalkyl vinyl ether-hexafluoro-propylene copolymers (EPE), tetrafluoroethylene-ethylene or propylenecopolymers (ETFE), polychlorotrifluoroethylene resins (PCTFE), ethylene-chlorotrifluoroethylene copolymers (ECTFE), vinylidene fluoride resins (PVDF), and polyvinyl fluorides (PVF) or coextruded sheets from polyester with EVA, polycarbonate, polyolefin, polyurethane, liquid crystal polymer, aclar, aluminum, of sputtered aluminum oxide polyester, sputtered silicon oxide or silicon nitride polyester, sputtered aluminum oxide polycarbonate, and sputtered silicon oxide or silicon nitride polycarbonate.

13. A flexible barrier substrate comprising a 10 to 100 nm thick inorganic oxide layer having a free pore volume of 0.3 to 10 % and a 0.5 to 10 nm layer obtained by atomic layer deposition .

14. A flexible barrier substrate according to claim 13 wherein the layer obtained by atomic layer deposition has a thickness of 0.5 to 5 nm.

15. A flexible barrier according to claim 13 wherein the inorganic oxide layer of thickness 10 to 100 nm is SiO₂ and the layer obtained by atomic layer deposition is Al₂O₃.

## Patentansprüche

1. Verfahren zur Herstellung einer Barriereschicht auf einem flexiblen Substrat, wobei das Verfahren umfasst:
- einen ersten Schritt, der ein Abscheiden einer anorganischen Oxidschicht auf dem flexiblen Substrat unter Verwendung eines Atmosphärendruckplasmas umfasst;
- einen zweiten Schritt, der eine anschließende Abscheidung von zwischen 1 und 70 Atomlagen auf der anorganischen Oxidschicht mit Atomlagenabscheidung umfasst.

2. Verfahren nach Anspruch 1, wobei der erste Schritt unter Verwendung eines Atmosphärendruck-Glimmentladung-Plasmageräts ausgeführt wird.

3. Verfahren nach einem der vorhergehenden Ansprüche, wobei der erste Schritt ein Abscheiden der anorganischen Oxidschicht mit einer Dicke zwischen 10 und 100 nm umfasst.

4. Verfahren nach einem der vorhergehenden Ansprüche, wobei der erste Schritt ein Abscheiden der anorganischen Oxidschicht umfasst, wobei die anorganische Oxidschicht ein freies Porenvolumen zwischen 0,3 und 10 % aufweist.

5. Verfahren nach einem der vorhergehenden Ansprüche, wobei der zweite Schritt unter Verwendung einer plasmagestützten Atomlagenabscheidung ausgeführt wird.

6. Verfahren nach einem der Ansprüche 1 bis 5, wobei der zweite Schritt unter Verwendung eines thermischen Atomlagenabscheidungsschritts ausgeführt wird.

7. Verfahren nach einem der vorhergehenden Ansprüche, wobei die anorganische Oxidschicht eine Siliciumoxidschicht ist.

8. Verfahren nach einem der vorhergehenden Ansprüche, wobei die im zweiten Schritt mit Atomlagenabscheidung abgeschiedene Schicht Al₂O₃ mit einer Dicke zwischen 0,5 und 10 nm ist.

9. Verfahren nach einem der Ansprüche 1 bis 7, wobei die im zweiten Schritt mit Atomlagenabscheidung abgeschiedene Schicht Al₂O₃ mit einer Dicke zwischen 0,5 und 5 nm ist.

10. Verfahren nach Anspruch 2, wobei im ersten Schritt eine anorganische Oxidschicht mit einer Abscheidungsrate zwischen 20 und 200 nm/s abgeschieden wird.

11. Verfahren nach einem der vorhergehenden Ansprüche, wobei das flexible Substrat ein PET- oder PEN-Film mit einer Dicke von 50 bis 200 µm ist.

12. Verfahren nach einem der Ansprüche 1 bis 10, wobei das Substrat eine transparente Folie aus Ethylenvinylacetat (EVA), aus Polyvinylbutyral (PVB), aus Polytetrafluorethylen (PTFE), Perfluoralkoxy-Harzen (PFA), d.h. Copolymeren aus Tetrafluorethylen und Perfluoralkylvinylether, Tetrafluorethylen-Hexafluorpropylen-Copolymeren (FEP), Tetrafluorethylen-Perfluoralkylvinylether-Hexafluorpropylen-Copolymeren (EPE), Tetrafluorethylen-Ethylen- oder -Propylen-Copolymeren (ETFE), Polychlortrifluorethylen-Harzen (PCTFE), Ethylen-Chlortrifluorethylen-Copolymeren (ECTFE), Vinylidenfluorid-Harzen (PVDF) und Polyvinylfluoriden (PVF) ist oder coextrudierte Folien aus Polyester mit EVA, Polycarbonat, Polyolefin, Polyurethan, Flüssigkristallpolymer, Aclar, Aluminium, aus Polyester mit aufgesputtertem Aluminiumoxid, Polyester mit aufgesputtertem Siliciumoxid oder Siliciumnitrid, Polycarbonat mit aufgesputtertem Aluminiumoxid und Polycarbonat mit aufgesputtertem Siliciumoxid oder Siliciumnitrid sind.

13. Flexibles Barrieresubstrat, das eine 10 bis 100 nm starke anorganische Oxidschicht mit einem freien Porenvolumen von 0,3 bis 10 % und eine 0,5 bis 10 nm starke Schicht umfasst, die mit Atomlagenabscheidung erhalten wird.

14. Flexibles Barrieresubstrat nach Anspruch 13, wobei die mit Atomlagenabscheidung erhaltene Schicht eine Dicke zwischen 0,5 und 5 nm aufweist.

15. Flexible Barriere nach Anspruch 13, wobei die anorganische Oxidschicht mit einer Dicke von 10 bis 100 nm SiO₂ ist und die mit Atomlagenabscheidung erhaltene Schicht Al₂O₃ ist.

## Revendications

1. Procédé pour la fabrication d'une couche barrière sur un substrat flexible, le procédé comprenant :
- une première étape comprenant le dépôt d'une couche d'oxyde inorganique sur le substrat flexible à l'aide d'un plasma à pression atmosphérique ;
- une deuxième étape comprenant le dépôt consécutif d'entre 1 et 70 couches atomiques sur la couche d'oxyde inorganique par dépôt en couches atomiques.

2. Procédé selon la revendication 1, la première étape étant réalisée à l'aide d'un appareil à plasma à décharge luminescente à pression atmosphérique.

3. Procédé selon l'une quelconque des revendications précédentes, la première étape comprenant le dépôt de la couche d'oxyde inorganique comportant une épaisseur comprise entre 10 et 100 nm.

4. Procédé selon l'une quelconque des revendications précédentes, la première étape comprenant le dépôt de la couche d'oxyde inorganique, la couche d'oxyde inorganique possédant un volume de pore libre compris entre 0,3 et 10 %.

5. Procédé selon l'une quelconque des revendications précédentes, la deuxième étape étant réalisée par dépôt en couches atomiques assisté par un plasma.

6. Procédé selon l'une quelconque des revendications 1 à 5, la deuxième étape étant réalisée à l'aide d'une étape de dépôt thermique en couches atomiques.

7. Procédé selon l'une quelconque des revendications précédentes, la couche d'oxyde inorganique étant une couche d'oxyde de silicium.

8. Procédé selon l'une quelconque des revendications précédentes, la couche déposée par dépôt en couches atomiques dans la deuxième étape étant en Al₂O₃ possédant une épaisseur comprise entre 0,5 et 10 nm.

9. Procédé selon l'une quelconque des revendications 1 à 7, la couche déposée par dépôt en couches atomiques dans la deuxième étape étant en Al₂O₃ possédant une épaisseur comprise entre 0,5 et 5 nm.

10. Procédé selon la revendication 2, où dans la première étape, une couche d'oxyde inorganique est déposée avec une vitesse de dépôt comprise entre 20 et 200 nm/s.

11. Procédé selon l'une quelconque des revendications précédentes, le substrat flexible étant un film de PET ou de PEN possédant une épaisseur de 50 à 200 µm.

12. Procédé selon l'une quelconque des revendications 1 à 10, le substrat étant une feuille transparente d'éthylène-acétate de vinyle (EVA), de poly(butyral de vinyle) (PVB), de polytétrafluoroéthylène (PTFE), de résines perfluoroalcoxy (PFA), c'est-à-dire de copolymères de tétrafluoroéthylène et de perfluoroalkyl vinyléther, de copolymères tétrafluoroéthylène-hexafluoropropylène (FEP), de copolymères tétrafluoroéthylène-perfluoroalkyl vinyléther-hexafluoropropylène (EPE), de copolymères tétrafluoroéthylène-éthylène ou -propylène (ETFE), de résines de polychlorotrifluoroéthylène (PCTFE), de copolymères éthylène-chlorotrifluoroéthylène (ECTFE), de résines de fluorure de vinylidène (PVDF), et de poly (fluorure de vinyle) (PVF) ou des feuilles coextrudées de polyester avec EVA, de polycarbonate, de polyoléfine, de polyuréthane, d'un polymère à cristaux liquides, en Aclar, d'aluminum, de polyester qui est pulvérisé avec l'oxyde d'aluminum, de polyester qui est pulvérisé avec l'oxyde de silicium ou nitrure de silicium, de polycarbonate qui est pulvérisé avec l'oxyde d'aluminum, et de polycarbonate qui est pulvérisé avec l'oxyde de silicium ou nitrure de silicium.

13. Substrat barrière flexible comprenant une couche d'oxyde inorganique d'une épaisseur de 10 à 100 nm possédant un volume de pore libre de 0,3 à 10 % et une couche de 0,5 à 10 nm obtenue par dépôt en couches atomiques.

14. Substrat barrière flexible selon la revendication 13, la couche obtenue par dépôt en couches atomiques possédant une épaisseur de 0,5 à 5 nm.

15. Barrière flexible selon la revendication 13, la couche d'oxyde inorganique d'une épaisseur de 10 à 100 nm étant en SiO₂ et la couche obtenue par dépôt en couches atomiques étant en Al₂O₃.
